(19) Europäisches Patentamt
European Patent Office
Office européen des brevets

(11) Veröffentlichungsnummer: **0 003 804**
**B1**

(12) # EUROPÄISCHE PATENTSCHRIFT

(45) Veröffentlichungstag der Patentschrift: **10.03.82**

(21) Anmeldenummer: **79100447.6**

(22) Anmeldetag: **15.02.79**

(51) Int. Cl.³: **G 03 F 7/10**, G 03 C 1/68 //G03F3/10, G03F7/12, G03C1/733, G03C7/02

(54) **Photopolymerisierbares Gemisch, das einen Monoazofarbstoff enthält.**

(30) Priorität: **24.02.78 DE 2807933**

(43) Veröffentlichungstag der Anmeldung:
**05.09.79 Patentblatt 79/18**

(45) Bekanntmachung des Hinweises auf die Patenterteilung
**10.03.82 Patentblatt 82/10**

(84) Benannte Vertragsstaaten:
**BE CH DE FR GB IT NL SE**

(56) Entgegenhaltungen:
**DE - A - 1 669 723**
**FR - A - 2 231 034**
**FR - A - 2 313 495**
**US - A - 3 130 050**

**COLOUR INDEX, 3. Auflage, 1971 Band 4, The Society of Dyers and Colourists, Bradford, *Seite 4013***

(73) Patentinhaber: **HOECHST AKTIENGESELLSCHAFT**
**Postfach 80 03 20**
**D-6230 Frankfurt/Main 80 (DE)**

(72) Erfinder: **Klüpfel, Kurt, Dr.**
**Dreispitzstrasse 1a**
**D-6200 Wiesbaden-Sonnenberg (DE)**
Erfinder: **Sprengel, Heide**
**Elsa Brandströmstrasse 10**
**D-6200 Wiesbaden 1 (DE)**
Erfinder: **Deucker, Walter, Dr.**
**Am Rehsteig 4**
**D-6232 Bad Soden 2 (DE)**
Erfinder: **Vollmann, Hansjörg W., Dr.**
**Am Dachsbau 11**
**D-6232 Bad Soden-Neuenhain (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**EP 0 003 804 B1**

Courier Press, Leamington Spa, England.

Photopolymerisierbares Gemisch, das einen Monoazofarbstoff enthält

Die Erfindung betrifft ein Photopolymerisierbares Gemisch, das polymerisierbare äthylenisch ungesättigte Verbindungen, polymere Bindemittel und Photoinitiatoren enthält.

Gemische dieser Art, die zur Herstellung von Druckplatten, Ätz- und Galvanoreserven und Reliefbildern dienen, sind bekannt, z.B. Aus den DE—PS 1 171 267, 2 027 467 und 2 039 861, der DE—AS 15 22 515 und der DE—OS 20 64 079.

Derartige Gemische oder Kopiermaterialien enthalten normalerweise Farbstoffe oder Pigmente in der photopolymerisierbaren Schicht, um verschiedene Schichttypen zu kennzeichnen und um das Reliefbild nach dem Entwickeln besser sichtbar zu machen. Diese farbigen Zusätze sollen naturgemäß möglichst lichtecht sein, da die nach dem Entwickeln verbleibende Bildschablone, die aus den lichtgehärteten Schichtteilen besteht, gut sichtbar sein soll.

Es ist auch, z.B. aus der DE—OS 23 31 377, bekannt, lichtempfindlichen Kopierschichten, die lichtempfindliche Diazoverbindungen enthalten, eine Kombination eines bestimmten Farbstoffs mit einer bei Belichtung eine Säure bildenden Verbindung zuzusetzen, um unmittelbar nach der Belichtung bereits das Bild in der Schicht erkennen zu können. Bei diesen Kombinationen sind, ebenso wie bei Verwendung vieler bekannter Farbstoffe, die bei Belichtung ausbleichen, die belichteten Schichtstellen nur schwach gefärbt. Bei negativ arbeitenden, d.h. lichthärtbaren Schichten führt das dazu, daß die entwickelte Bildschablone nur einen geringen visuellen Kontrast zur Trägeroberfläche zeigt.

Aus der US—PS 3 130 150 ist es ferner bekannt, photopolymerisierbaren Schichten bestimmte öllösliche Farbstoffe, darunter auch Monoazofarbstoffe, zuzusetzen, um — wie oben erwähnt — das erhaltene Reliefbild besser sichtbar zu machen. Die Farbstoffe werden hier in einem hydrophoben organischen Lösungsmittel gelöst und in der wäßrigen Beschichtungslösung dispergiert. Von einer Änderung des Farbtons bei der Belichtung ist nichts angegeben.

Aufgabe der Erfindung war es, ein photopolymerisierbares Gemisch bereitzustellen, das in einer Weise angefärbt ist, daß eine damit hergestellte Kopierschicht vor dem Belichten intensiv gefärbt ist und sowohl nach dem Belichten als auch nach dem Entwickeln ein kontrastreiches Bild erkennen läßt.

Die Erfindung geht aus von einem photopolymerisierbaren Gemisch, das eine zur Additionspolymerisation befähigte Verbindung mit mindestens zwei entständigen äthylenisch ungesättigten Gruppen und einem Siedepunkt oberhalb 100°C, ein polymeres Bindemittel, einen Photoinitiator und einen Farbstoff enthält.

Die vorstehende Aufgabe wird dadurch gelöst, daß als Farbstoff ein Monoazofarbstoff der Formel I

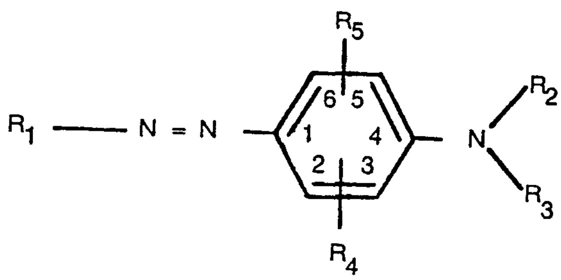

(I)

verwendet wird, worin

$R_1$

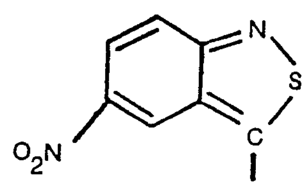

oder

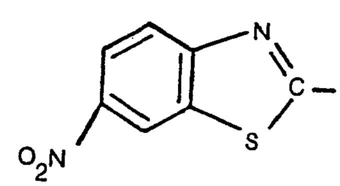

$R_2$ und $R_3$ gegebenenfalls substituierte Alkyl- oder Alkenylreste und

$R_4$ und $R_5$ Wasserstoff- oder Halogenatome, Alkyl- oder Alkoxygruppen

bedeuten.

Die Reste $R_2$ und $R_3$ sind bevorzugt unsubstituiert oder durch Hydroxy-, Alkoxy-, Cyano-, Acyloxy-, Alkoxycarbonyl-, Alkylaminocarbonyloxygruppen oder Halogenatome substituiert.

Die unsubstituierten Alkyl- bzw. Alkenylreste $R_2$ und $R_3$ haben im allgemeinen 1 bis 8, vorzugsweise 2 bis 5 C-Atome. Die Alkylgruppen der Substituenten haben im allgemeinen 1 bis 3, vorzugsweise 1 C-Atom.

Wenn die Kernsubstituenten $R_4$ und $R_5$ Alkyl- oder Alkoxygruppen sind, haben sie vorzugsweise 1 bis 3 C-Atome. Bevorzugt ist mindestens einer der Reste $R_4$ und $R_5$ ein Wasserstoffatom.

Als Halogenatome für die Substituenten in $R_2$ und $R_3$ und für die Reste $R_4$ und $R_5$ werden Chlor und Brom bevorzugt.

Die in dem erfindungsgemäßen Gemisch verwendeten Farbstoffe sind an sich bekannt und in der DE—PS 1 544 375 und der DE—OS 25 24 481 beschrieben.

Die erfindungsgemäßen photopolymerisierbaren Gemische zeigen, wenn sie als feste photopolymerisierbare Schicht einer Bildbelichtung unterworfen werden, an den belichteten Stellen eine deutlich sichtbare Entfärbung, so daß das aufgezeichnete Bild deutlich erkennbar ist. Dabei werden bis zu 50% der ursprünglichen Extinktion ausgebleicht. Läßt man die belichteten Materialien insbesondere unter Zutritt von Luftsauerstoff liegen, so wird allmählich die ursprüngliche Farbdichte regeneriert. Nach 60 Minuten werden bis zu 90% der ursprünglichen Extinktion erreicht.

Dieses überraschende Verhalten der Farbstoffe ist an die Kombination mit den übrigen Bestandteilen des photopolymerisierbaren Gemischs geknüpft. Die Farbstoffe selbst zeigen in fester Form oder in Lösung kein Ausbleichen und demnach keine Farbdichteregeneration.

Durch die Erfindung wird erreicht, daß die Bildbelichtung der photopolymerisierbaren Schichten unmittelbar erkennbar ist, und daß man nach dem Entwickeln, d.h. dem Auswaschen der unbelichteten Schichtbereiche, nach kurzer Lagerung wieder eine kontrastreich gefärbte Bildschablone erhält.

Das erfindungsgemäße lichtempfindliche Gemisch kann in bakannter Weise als Lösung oder Dispersion in den Handel gebracht werden, die vom Verbraucher insbesondere zur Herstellung von Ätzschutzschichten verwendet wird. Ein bevorzugtes Anwendungsgebiet sind Trockenresistfilme, die aus einer auf einem Zwischenträger befindlichen trockenen thermoplastischen Photoresistschicht bestehen, die vom Verbraucher auf die zu ätzende oder bildmäßig zu galvanisierende Unterlage aufkaschiert, dann belichtet und nach dem Abziehen des Zwischenträgers, der zumeist aus einer Kunststoffolie besteht, entwickelt werden.

Das erfindungsgemäße Gemisch eignet sich besonders gut für diese Anwendungsform. Es kann aber auch in Form eines vorsensibilisierten Kopiermaterials auf einem geeigneten Träger, so z.B. auf Aluminium oder Zink, für die photomechanische Herstellung von Offset- oder Hochdruckformen fabrikmäßig hergestellt werden. Es ist ferner zur Herstellung von Reliefbildern, Siebdruckschablonen, Farbprüffolien und dgl. geeignet.

Das erfindungsgemäße Gemisch besteht im wesentlichen aus Monomeren, Photoinitiatoren, Bindemitteln und den beschriebenen Farbstoffen; es kann jedoch noch eine Reihe weiterer Zusätze enthalten, z.B.

Stabilisatoren bzw. Inhibitoren zur Verminderung der thermischen Polymerisation der Kopierschicht,
Wasserstoffdonatoren,
Weichmacher,
sensitometrische Regler und ungefärbte Pigmente.

Als Photoinitiatoren eignen sich eine Vielzahl von Substanzen, beispielsweise Benzoin, Benzoinäther, Mehrkernchinone, z.B. 2-Äthyl-anthrachinon; Acridinderivate, z.B. 9-Phenyl-acridin, 9-p-Methoxyphenyl-acridin, 9-Acetylamino-acridin, Benz(a)acridin; Phenazinderivate, z.B. 9,10-Dimethyl-benz(a)phenazin, 9-Methyl-benz(a)phenazin, 10-Methoxy-benz(a)phenazin; Chinoxalinderivate, z.B. 6,4',4''-Trimethoxy-2,3-diphenyl-chinoxalin, 4,4''-Dimethoxy-2,3-diphenyl-5-aza-chinoxalin; Chinazolinderivate; synergistische Mischungen verschiedener Ketone; Farbstoff/Redoxsysteme; Thiopyryliumsalze und dgl. mehr.

Für die Zwecke der Erfindung geeignete photopolymerisierbare Monomere sind bekannt und z.B. in den USA-Patentschriften 2 760 863 und 3 060 023 beschrieben.

Bevorzugte Beispiele sind Acryl- und Methacrylsäureester, wie Diglycerindiacrylat, Polyäthylenglykoldimethacrylat, Acrylate und Methacrylate von Trimethyloläthan, Trimethylolpropan und Pentaerythrit und von mehrwertigen alicyclischen Alkoholen. Besonders vorteilhaft werden Umsetzungsprodukte von Diisocyanaten mit Partialestern mehrwertiger Alkohole eingesetzt. Derartige Monomere sind in den DE—OS 2 064 079 und DE—OS 23 61 041 beschrieben. Generell werden die Methacrylate gegenüber den Acrylaten bevorzugt.

Als Wasserstoffdonatoren werden in der Hauptsache aliphatische Polyäther verwendet. Gegebenenfalls kann diese Funktion auch vom Bindemittel oder von dem polymerisierbaren Monomeren übernommen werden, wenn diese labile Wasserstoffatome besitzen.

Als Bindemittel können eine Vielzahl löslicher organischer Polymerisate Einsatz finden. Als Beispiele seien genannt: Polyamide, Polyvinylester, Polyvinylacetale, Polyvinyläther, Polyacrylsäureester, Polymethacrylsäureester, Polyester, Alkydharze, Polyacrylamid, Polyvinylalkohol, Polyäthylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Ferner kommen als Bindemittel Naturstoffe oder umgewandelte Naturstoffe in Betracht, z.B. Gelatine, Celluloseäther und dgl.

Mit besonderem Vorteil werden Bindemittel verwendet, die in wäßrig-alkalischen Lösungen löslich oder mindestens quellbar sind, da sich Schichten mit solchen Bindemitteln mit den bevorzugten waßrig-alkalischen Entwicklern entwickeln lassen. Derartige Bindemittel können z.B. die folgenden Gruppen enthalten: —COOH, —$PO_3H_2$, —$SO_3H$, —$SO_2NH_2$, —$SO_2$—NH—CO— und dgl.. Als beispiele hierfür seien genannt: Maleinatharze, Polymerisate aus N-(p-Tolylsulfonyl)-carbaminsäure-(β-methacryloyloxy-äthyl)-ester und Mischpolymerisate dieser und ähnlicher Monomerer mit anderen Monomeren, Styrol-Maleinsäureanhydrid-Mischpolymerisate und Methylmethacrylat-Methacrylsäure-Mischpolymerisate. Vorzugsweise werden Mischpolymerisate aus Methacrylsäure, Alkylmethacrylaten und Methylmethacrylat und/oder Styrol, Acrylnitril u.a. wie sie in den DE—OS 2 064 080 und 2 363 806 beschrieben sind, verwendet.

Als Schichtträger für mit dem erfindungsgemäßen Gemisch hergestellte Kopiermaterialien sind beispielsweise Aluminium, Stahl, Zink, Kupfer oder Kunststoff-Folien, z.B. aus Polyäthylenterephthalat oder Celluloseacetat, geeignet. Die Trägeroberfläche kann chemisch oder mechanisch vorbehandelt werden, um die Haftung der Schicht richtig einzustellen bzw. das Reflexionsvermögen des Trägers im aktinischen Bereich der Kopierschicht herabzusetzen (Lichthofschutz).

Die Herstellung der lichtempfindlichen Materialien unter Verwendung des erfindungsgemäßen Gemischs erfolgt in bekannter Weise. So kann man diese in einem Lösungsmittel aufnehmen und die Lösung bzw. Dispersion durch Gießen, Sprühen, Tauchen, Antrag mit Walzen usw. auf den vorgesehenen Träger als Film antragen und anschließend antrocknen.

Dicke Schichten (z.B. von 250 $\mu$m und darüber) kann man durch Extrudieren oder Verpressen als selbsttragende Folie herstellen, welche dann auf den Träger laminiert wird.

Die Kopierschichten werden in bakannter Weise belichtet und entwickelt. Als Entwickler sind vorzugsweise wäßrigalkalische Lösungen, z.B. von Alkaliphosphaten, Alkaliboraten, Alkalicarbonaten oder Alkalisilikaten, geeignet, denen ggf. kleine Mengen an Netzmitteln und/oder mit Wasser mischbaren organischen Lösungsmitteln zugesetzt werden können. Als Alkalien sind außerdem wäßrige Lösungen aliphatischer Amine geeignet, die in besonderen Fällen abgepuffert sein können.

Die erfindungsgemäßen Gemische lassen sich, wie oben erwähnt, für die verschiedensten Anwendungsgebiete einsetzen. Mit besonderem Vorteil werden sie direkt oder in Form eines Trockenresistfilms zur Herstellung von Reservagen, d.h. Ätzschutzschichten bzw. Galvanoreserven, auf metallischen Trägern wie z.B. Kupfer verwendet, das unter anderem zur Herstellung von kopierten Schaltungen, von Tiefdruckformen und von Mehrmetall-Offsetdruckformen verwendet wird.

Der Mengenanteil der oben beschriebenen Monoazofarbstoffe in der erfindungsgemäßen photopolymerisierbaren Masse liegt im allgemeinen bei 0,02 bis 3 Gew.-%, bevorzugt bei 0,1 bis 1 Gew.-%, bezogen auf die nichtflüchtigen Bestandteile. Die polymerisierbaren Verbindungen werden im allgemeinen in einer Menge von 20 bis 80 Gew.-%, bezogen auf das Gewicht von Bindemittel und polymerisierbarer Verbindung eingesetzt. Der Gehalt der Masse an Photoinitiatoren liegt gewöhnlich zwischen 0,1 und 10 Gew.-% der nichtflüchtigen Bestandteile.

In der folgenden Tabelle I sind Monoazofarbstoffe der Formel I zusammengestellt, die in erfindungsgemäßen photopolymerisierbaren Gemischen erprobt wurden. Dabei bedeutet $R_1$ in den Verbindungen 1 bis 9 die Nitrobenzisothiazolylgruppe, in den Verbindungen 10 und 11 die Nitrobenzthiazolylgruppe. $R_5$ ist in allen Verbindungen ein Wasserstoffatom.

TABELLE I

| Verbindung Nr. | $R_2$ | $R_3$ | $R_4$ | Farbe der Schicht | Extinktion bei λmax für 10 mg Farbstoff je 1000 $cm^3$ Methyl-äthylketon |
|---|---|---|---|---|---|
| 1 | $C_2H_5$ | $C_2H_4CN$ | 2-$CH_3$ | blau | 590 nm / 0,667 |
| 2 | $C_2H_4OH$ | $C_2H_4OH$ | 2-Cl | tiefblau | 593 nm / 0,749 |
| 3 | $C_2H_4OH$ | $C_2H_4CN$ | H | blauviolett | 576 nm / 0,822 |
| 4 | $C_2H_5$ | $C_2H_4OCONHCH_3$ | ,, | tiefblau | 589 nm / 0,822 |
| 5 | $C_2H_4COOCH_3$ | $CH_2-CH=CH_2$ | 2-$CH_3$ | blau | 595 nm / 0,646 |
| 6 | $C_2H_4OH$ | $CH_2-C(CH_3)=CH_2$ | H | blau | 593 nm / 0,683 |
| 7 | $C_2H_4OH$ | $CH_2-CH=CH_2$ | ,, | tiefblau | 592 nm / 0,959 |
| 8 | $C_2H_4CN$ | $CH_2-CH=CH_2$ | ,, | violett | 568 nm / 0,581 |
| 9 | $C_2H_4OH$ | $CH_2-CBr=CH_2$ | ,, | blauviolett | 583 nm / 0,622 |
| 10 | $C_2H_4CN$ | $C_2H_4OCOCH_3$ | ,, | rot | 515 nm / 1,223 |
| 11 | $C_2H_5$ | $C_2H_4CN$ | 2-$CH_3$ | rotviolett | 535 nm / 1,350 |

Die folgenden Beispiele erläutern die Anwendung dieser Farbstoffe in photopolymerisierbaren Gemischen.

Beispiel 1

Es wird eine Lösung der folgenden Bestandteile hergestellt:

5,6 g des Umsetzungsproduktes aus 1 Mol 2,2,4-Trimethyl-hexamethylen-diisocyanat und 2 Mol 2-Hydroxy-äthylmethacrylat

6,5 g eines Terpolymerisats aus Styrol, n-Hexylmethacrylat und Methacrylsäure (10 : 60 : 30) mit einer Säurezahl von ca. 190

0,2 g 9-Phenylacridin

0,15 g Triäthylenglykol-dimethacrylat

0,015 g 4,4'-Bis-dimethylamino-benzophenon

0,035 g Farbstoff (Verbindungen der Formeln 1 bis 11)

28 g Butanon-2

Die Lösung wird auf eine 25 μm starke biaxial verstreckte und thermofixierte Polyäthylenterephthalatfolie so aufgeschleudert, daß nach dem Trocknen eine 25 μm (30 g/$m^2$) dicke Schicht erhalten wird. Es wird 2 Minuten bei 100°C im Trockenschrank nachgetrocknet.

Um die erhaltene Schicht vor Verschmutzung durch Staub und Beschädigungen zu schützen, wird sie mit einer 25 μm starken Deckfolie aus Polyäthylen abgedeckt.

Normalerweise wird das Kopiermaterial in der Weise verarbeitet, daß die Resistschicht nach Abziehen der Deckfolie auf eine Kupferoberfläche laminiert, durch die Trägerfolie belichtet, die Trägerfolie abgezogen und die nicht gehärteten Schichtteile mit einem Entwickler ausgewaschen werden.

Um aber den Ausbleich- und Regenerierungseffekt der Farbstoffe besser messen zu können, wird wie folgt verfahren:

Eine 20 × 40 mm große Fläche wird aus dem Trockenresistmaterial ausgeschnitten; die Deckfolie wird abgezogen und die Extinktion der unbelichteten Schicht mit Hilfe einer Integrations-Kugel ("Ulbricht-Kugel") in einem Zeiss-Spektralphotometer DM R — 21 gemessen. Die Meßwerte sind in

Spalte 2 der Tabelle II angegeben, in Spalte 1 stehen die gegenüber dem reinen Farbstoff geringfügig verschobenen Absorptionsmaxima.

Eine gleichzeitig ausgeschnittene Probe wird unter einer 5 kW MH-Lampe der Firma Staub, Neu-Isenburg, 16 Sekunden ohne Vorlage belichtet, wobei es wegen der geringen Absorption von Träger- und Deckfolie unerheblich ist, durch welche Folie belichtet wird.

Für den Transport vom Belichtungsgerät bis zur Messung wurden 4 Minuten angesetzt. Dann wurde die Deckfolie abgezogen und nach weiteren 2 Minuten die Extinktion gemessen (Spalte 3 in Tabelle II).

Nach 1 Stunde wurde erneut die Extinktion gemessen (Spalte 4).

Der gleiche Vorgang wurde nach 60 Stunden wiederholt (Spalte 5). Nach etwa 10 Tagen werden wieder fast 100% der ursprünglichen Farbdichte erreicht.

TABELLE II

| Farbstoff Nr. und λmax der photopolymerisierbaren Schicht | Extinktion unbelichtet (y) | Probe belichtet Extinktion nach Stunden 0,1 | 1 | 60 (X) | $\frac{x}{y} \cdot 100$ | Anstieg der Extinktion von 0,1 bis 60 Stunden |
|---|---|---|---|---|---|---|
| 1: 597 nm | 0,590 | 0,36 | 0,48 | 0,48 | 81,35 % | 0,120 |
| 2: 595 nm | 0,608 | 0,41 | 0,54 | 0,58 | 95,4[illegible] % | 0,170 |
| 3: 585 nm | 0,642 | 0,39 | 0,549 | 0,575 | 89,56 % | 0,185 |
| 4: 595 nm | 0,694 | 0,469 | 0,588 | 0,595 | 85,75 % | 0,126 |
| 5: 605 nm | 0,631 | 0,398 | 0,47 | 0,49 | 77,7 % | 0,092 |
| 6: 596 nm | 0,560 | 0,328 | 0,45 | 0,47 | 83,9 % | 0,142 |
| 7: 600 nm | 0,886 | 0,610 | 0,773 | 0,780 | 88,0 % | 0,170 |
| 8: 575 nm | 0,508 | 0,202 | 0,410 | 0.452 | 88,9 % | 0,250 |
| 9: 580 nm | 0,511 | 0,309 | 0,440 | 0,442 | 86,5 % | 0,133 |
| 10: 525 nm | 0,805 | 0,477 | 0,670 | 0,735 | 91,3 % | 0,258 |
| 11: 545 nm | 0,949 | 0,590 | 0,725 | 0,810 | 85,2 % | 0,220 |

Beispiel 2

Eine Lösung der folgenden Bestandteile wird hergestellt:

| | | |
|---|---|---|
| 115 | g | einer 33%igen Lösung von Poly-Methylmethacrylat/Methacrylsäure (82 : 18) in Butanon-2 mit einer Säurezahl von ca. 115 |
| 39,2 | g | Trimethyloläthantriacrylat |
| 0,7 | g | 9-Phenylacridin |
| 0,7 | g | 4-Dimethylamino-4'-methyl-dibenzalaceton |
| 0,14 | g | Farbstoff |
| 42 | g | Glykolmonoäthyläther |
| 14 | g | n-Butylacetat |

Als Farbstoffe werden die Verbindungen der Formeln 3, 7 und 11 verwendet.

Die einzelnen Lösungen, die die Farbstoffe enthalten, werden wie in Beispiel 1 beschrieben verarbeitet.

Die Ergebnisse zeigt die folgende Tabelle III.

TABELLE III

| Farbstoff Nr. und λmax der photopolymerisierbaren Schicht | Extinktion unbelichtet (y) | Probe belichtet Extinktion nach Stunden | | (X) | $\frac{x}{y} \cdot 100$ | Anstieg der Extinktion von 0,1 bis 60 Stunden |
|---|---|---|---|---|---|---|
| | | 0,1 | 1 | 60 | | |
| 3: 580 nm | 0,503 | 0,261 | 0,37 | 0,38 | 75,5 % | 0,119 |
| 7: 597 nm | 0,650 | 0,381 | 0,471 | 0,475 | 73,0 % | 0,094 |
| 11: 545 nm | 0.893 | 0,568 | 0,72 | 0,73 | 81,7 % | 0,162 |

**Patentansprüche**

1. Photopolymerisierbares Gemisch, das eine zur Additionspolymerisation befähigte Verbindung mit mindestens zwei endständigen äthylenisch ungesättigten Gruppen und einem Siedepunkt oberhalb 100°C, ein polymeres Bindemittel, einen Photoinitiator und einen Monoazofarbstoff enthält, dadurch gekennzeichnet, daß der Monoazofarbstoff eine Verbindung der Formel I

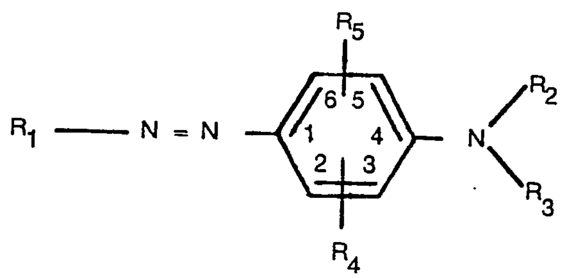

(I)

ist, worin

$R_1$

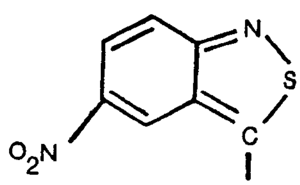

oder

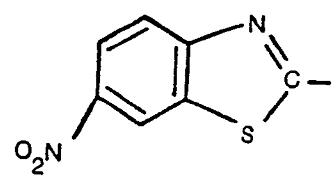

$R_2$ und $R_3$ gegebenenfalls substituierte Alkyl- oder Alkenylreste und
$R_4$ und $R_5$ Wasserstoff- oder Halogenatome, Alkyl- oder Alkoxygruppen
bedeuten.

2. Photopolymerisierbares Gemisch nach Anspruch 1, dadurch gekennzeichnet, daß der Farbstoff eine Verbindung der Formel I ist, worin
$R_2$ und $R_3$ Alkyl- oder Alkenylreste bedeuten, die durch Hydroxy-, Alkoxy-, Cyano-, Acyloxy-, Alkoxycarbonyl-, Alkylaminocarbonyloxygruppen oder Halogenatome substituiert sind.

3. Photopolymerisierbares Gemisch nach Anspruch 1, dadurch gekennzeichnet, daß es 0.1 bis 1,0 Gew.-% einer Verbindung der Formel I, bezogen auf das Gewicht der nichtflüchtigen Bestandteile, enthält.

4. Photopolymerisierbares Gemisch nach Anspruch 1, dadurch gekennzeichnet, daß es als feste photopolymerisierbare Schicht auf einem Schichtträger vorliegt.

**Revendications**

1. Mélange photopolymérisable contenant un composé susceptible de se polymériser par addition, renfermant au moins deux groupes terminaux éthyléniquement insaturés et présentant un point d'ébullition supérieur à 100°C, un liant polymère, un photo-initiateur et un colorant, caractérisé en ce que le colorant est du type mono-azoïque de formule I

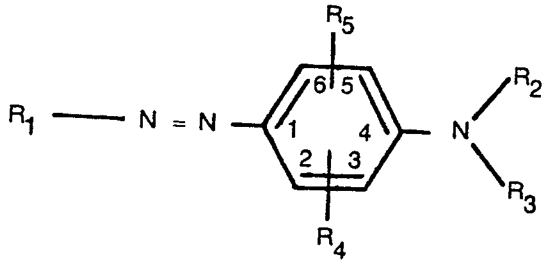 (I)

dans laquelle:

$R_1$ est:

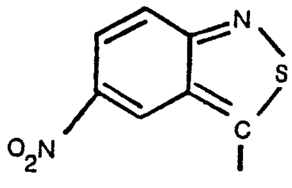 ou: 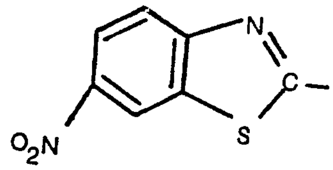

$R_2$ et $R_3$ sont des restes alkyle ou alcényle éventuellement substitués et,

$R_4$ et $R_5$ sont des atomes d'hydrogène ou d'halogène, de groupes alkyle ou alcoxy.

2. Mélange photopolymérisable selon la revendication 1, caractérisé en ce que le colorant est un composé de formule I dans laquelle

$R_2$ et $R_3$ sont des restes alkyle ou alcényle substitués par des groupes hydroxyle, alcoxy, nitrile, acyloxy, alcoxy carbonyle, alkylaminocarbonyloxy ou par des atomes d'halogène.

3. Mélange photopolymérisable selon la revendication 1, caractérisé en ce qu'il comprend entre 0,1 et 1,0% en poids d'un composé de formule I, calculé par rapport au poids des ingrédients non volatils.

4. Mélange photopolymérisable selon la revendication 1, caractérisé en ce qu'il se trouve sous la forme d'une couche photopolymérisable solide sur un support de couche.

**Claims**

1. A photopolymerizable mixture comprising a compound with at least two terminal ethylenically unsaturated groups and a boiling point above 100°C, which is capable of addition polymerization, a polymeric binder, a photoinitiator, and a monoazo dye, characterized in that the monoazo dye is a compound corresponding to Formula I:

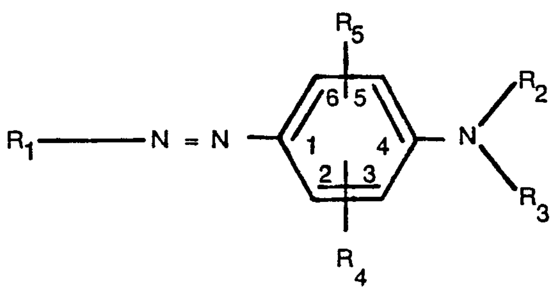 (I)

wherein

$R_1$ is

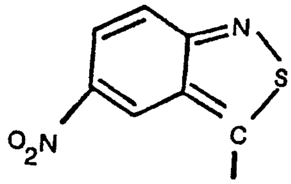 or 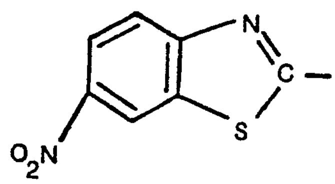

$R_2$ and $R_3$ are alkyl or alkenyl groups which may be substituted, and

$R_4$ and $R_5$ are hydrogen or halogen atoms, or alkyl or alkoxy groups.

2. A photopolymerizable mixture according to claim 1, characterized in that the dye is a dye corresponding to Formula I wherein

$R_2$ and $R_3$ are alkyl or alkenyl groups which are substituted by hydroxy, alkoxy, cyano, acyloxy, alkoxycarbonyl or alkylamino carbonyloxy groups, or by halogen atoms.

3. A photopolymerizable mixture according to claim 1, characterized in that it contains between 0.1 and 1.0 per cent by weight of a compound corresponding to Formula I, calculated on the weight of the nonvolatile components of the mixture.

4. A photopolymerizable mixture according to claim 1, characterized in that it is in the form of a solid photopolymerizable layer disposed on a support.